# EUROPÄISCHE PATENTSCHRIFT

(11) **EP 0 556 690 B1**
(45) Veröffentlichungstag und Bekanntmachung des Hinweises auf die Patenterteilung: **13.05.1998**
(21) Anmeldenummer: 93101982.2
(22) Anmeldetag: 09.02.1993
(51) Int. Cl.: G03F 7/30

(54) **Verfahren und Vorrichtung zum Entwickeln von strahlungsempfindlichen, belichteten Druckformen**
Process and apparatus for developing photosensitive, exposed printing plates
Procédé et appareil pour développer des plaques d'impression photosensibles, exposées

(30) Priorität: 17.02.1992 DE 4204691
(43) Veröffentlichungstag der Anmeldung: 25.08.1993
(73) Patentinhaber: Agfa-Gevaert AG, 51373 Leverkusen (DE)
(72) Erfinder: Stein, Eckehard, Dipl.-Ing., W-6000 Frankfurt/M. 71 (DE); Jürgensen, Peter Jessen, Dipl.-Ing., DK-2830 Virum (DK)
(74) Vertreter: Zounek, Nikolai, Dipl.-Ing.

(56) Entgegenhaltungen:
- EP-A- 0 383 314
- US-A- 4 977 067
- PATENT ABSTRACTS OF JAPAN vol. 008, no. 248 (P-313) 14. November 1984 & JP-A-59 121 047
- PATENT ABSTRACTS OF JAPAN vol. 010, no. 225 (P-484) 6. August 1986 & JP-A-61 061 164
- PATENT ABSTRACTS OF JAPAN vol. 015, no. 023 (P-1155) 18. Januar 1991 & JP-A-22 67 560
- PATENT ABSTRACTS OF JAPAN vol. 015, no. 430 (P-1270) 31. Oktober 1991 & JP-A-31 77 843
- PATENT ABSTRACTS OF JAPAN vol. 016, no. 171 (P-1343) 24. April 1992 & JP-A-40 15 653
- PATENT ABSTRACTS OF JAPAN vol. 013, no. 464 (P-947) 20. Oktober 1989 & JP-A-11 80 548
- PATENT ABSTRACTS OF JAPAN vol. 010, no. 127 (P-455)(2184) 13. Mai 1986 & JP-A-60 252 351
- PATENT ABSTRACTS OF JAPAN vol. 010, no. 135 (P-457)(2192) 20. Mai 1986 & JP-A-60 257 449

## Beschreibung

Die Erfindung betrifft ein Verfahren zum Entwicklen von strahlungsempfindlichen, belichteten Druckformen in einer Entwicklerlösung, deren elektrische Leitfähigkeit fortlaufend gemessen wird, wobei in Abhängigkeit von dem Flächendurchsatz der Druckformen durch die Entwicklerlösung und der Leitfähigkeit durch Zugabe von Komponenten der Entwicklerlösung die Leitfähigkeit der Entwicklerlösung in Richtung eines Sollwertes geregelt wird, und eine Vorrichtung zur Durchführung dieses Verfahrens.

Ein derartiges Verfahren ist aus der EP-A-0 383 314 bekannt, bei dem eine Entwicklungsvorrichtung eingesetzt wird, in der die Entwicklerflüssigkeit in der Entwicklungsstation mit konzentrierter Entwicklerflüssigkeit bzw. Entwicklerregenerat in Abhängigkeit von dem Flächendurchsatz einer Druckplatte aufgefüllt wird. Desweiteren wird die elektrische Leitfähigkeit der Entwicklerflüssigkeit fortlaufend gemessen. Auf diese Weise wird der Wasseranteil in der Entwicklerlösung gleichzeitig gemessen. Verdampft Wasser aus der Entwicklerflüssigkeit, so steigt die Konzentration des Entwicklers in der Entwicklerflüssigkeit an und die elektrische Leitfähigkeit der Entwicklerflüssigkeit muß abgesenkt werden. Die Zugabe von Wasser verhindert den Konzentrationsanstieg des Entwicklers in der Entwicklerflüssigkeit. Sobald die Leitfähigkeit einen vorgegebenen Wert überschreitet, erfolgt die Zugabe von Wasser zu der Entwicklerflüssigkeit. Bei diesem Verfahren hängt die Zugabe von Entwicklerregenerat einzig und allein von dem Flächendurchsatz der Druckplatten ab. Wenn in einem weiteren Schritt Wasser der Entwicklerflüssigkeit zugegeben wird, so geschieht dies, um die Entwicklerkonzentration in der Entwicklerflüssigkeit und somit die elektrische Leitfähigkeit der Entwicklerflüssigkeit konstant zu halten

Aus der EP-A-0 107 454 sind ein Verarbeitungsverfahren und eine Vorrichtung für eine Anzahl von bildweise belichteten, strahlungsempfindlichen Platten bekannt, die in Kontakt mit einer Verarbeitungsflüssigkeit gebracht werden, wobei die Veränderungen der elektrischen Leitfähigkeit der Verarbeitungsflüssigkeit während des Verfahrens beobachtet und die Verarbeitungsbedingungen in Abhängigkeit von den Änderungen der elektrischen Leitfähigkeit variiert werden. Bei der Verarbeitungsflüssigkeit handelt es sich entweder um eine Entwicklerflüssigkeit, einen Finisher oder ein Hydrophilierungsmittel. Der Verarbeitungsflüssigkeit kann desweiteren ein lithographisch inertes Material zugegeben sein, das in Lösung ionisiert wird, um die elektrische Leitfähigkeit zu erhöhen.

Die bekannte Vorrichtung für das Verarbeiten der bildweise belichteten, strahlungsempflindlichen Platten umfaßt einen Behälter für die Verarbeitungsflüssigkeit und eine Einrichtung zum Bewegen der Platten entlang eines Bades durch die Vorrichtung, so daß sie in Kontakt mit der Verarbeitungsflüssigkeit sind.

Die Vorrichtung enthält eine Einrichtung zum Messen der elektrischen Leitfähigkeit der Verarbeitungsflüssigkeit und zum Erzeugen eines Ausgangssignals in Abhängigkeit von der Leitfähigkeit und eine Einrichtung zum Verändern der Verarbeitungsbedingungen in Abhängigkeit von dem Ausgangssignal. Die Einrichtung zum Verändern der Verarbeitungsbedingungen enthält u.a. einen variablen Geschwindigkeitsmotor für den Antrieb der Plattenbewegungseinrichtung, wobei der Motor durch das Ausgangssignal so geregelt wird, daß das Zeitintervall, in dem die Platten in Kontakt mit der Verarbeitungsflüssigkeit sind, von der Leitfähigkeit der Verarbeitungsflüssigkeit abhängt. Bei diesem bekannten Verfahren und der hierfür vorgesehenen Vorrichtung wird von der Voraussetzung ausgegangen, daß bei gleichbleibender elektrischer Leitfähigkeit bzw. gleichbleibendem Leitwert auch stets eine gleiche Wiedergabe nach der Entwicklung der Platten erhalten wird.

Aus der DE-A - 30 07 401 ist ein Verfahren zur Entwicklung einer bildweise belichteten, positiv arbeitenden, lichtempfindlichen lithographischen Druckplatte und zur Konstanthaltung der Aktivität eines alkalischen Entwicklers während der Entwicklung bekannt, bei dem eine erste Zugabe mit einer höheren Alkalinität als derjenigen des alkalischen Entwicklers bei jeder Behandlung des lichtempfindlichen Materials zugesetzt wird und ferner eine zweite Zugabe mit einer höheren Alkalinität als derjenigen des Entwicklers entweder kontinuierlich in einer bestimmten Menge oder in bestimmten Abständen in bestimmten Mengen zugesetzt wird. Die erste Zugabe bzw. das erste Regenerat zu dem Entwickler wird in einer bestimmten Menge proportional zur Länge einer Seite des zu behandelnden lichtempfindlichen Materials zugesetzt.

Die im Stand der Technik zu Druckplatten zu entwickelnden strahlungsempfindlichen Druckformen, insbesondere lithographische Druckformen, bestehen im allgemeinen aus einem Metallträger, insbesondere einem Aluminiumträger, der mechanisch oder chemisch aufgerauht wird, um eine entsprechend geeignete hydrophile Oberfläche zu erhalten, auf der dann eine strahlungsempfindliche Beschichtung aufgebracht wird. Solche Druckformen mit strahlungsempfindlichen Schichten werden bildweise durch ein Positiv- oder Negativtransparent belichtet. Die einfallende Strahlung ändert die Löslichkeit der strahlungsempfindlichen Beschichtung. Anschließend wird die bildweise belichtete Druckform verarbeitet, indem die belichtete Druckform mit einer Entwicklerlösung in Kontakt gebracht wird, um selektiv diejenigen Flächen der Beschichtung zu entfernen, die für die Bildentwicklung nicht erforderlich sind. Nach dem Entwicklungsschritt wird die Druckform im allgemeinen gereinigt und gewaschen und mit einem Finisher und Hydrophilierungsmittel behandelt, deren Hauptzweck darin besteht, die entwickelte Druckplatte zu schützen und/oder die Nichtbildflächen zu hydrophilieren.

Bei der Entwicklung von belichteten Druckformen zu Druckplatten ergibt sich das Problem, daß der Entwickler bzw. die Entwicklerlösung durch den Entwicklungsvorgang geschwächt wird. Diese Abschwächung des Entwicklers führt zu einer volleren Bildwiedergabe auf der Druckform, was keineswegs der Forderung nach einem standardisierten Drucken von der fertig entwickelten Druckplatte entspricht.

Die Überwachung der Bildwiedergabe erfolgt im allgemeinen durch Mitkopieren von Testelementen. Sobald eine Abschwächung der Entwicklerwirksamkeit über die Testelemente festgestellt wird, werden die abgeschwächten Entwicklerlösungen durch Zugaben eines Regenerats aufgefrischt bzw. verstärkt. Die Wirksamkeit dieser Regeneratzugabe wird ebenfalls durch das Mitkopieren von Testelementen und/oder durch Messung der elektrischen Leitfähigkeit bzw. des Leitwertes geprüft.

In der Praxis zeigt sich dabei, daß verschiedene bekannte Entwicklungssysteme aus Entwickler bzw. Entwicklerlösung und Regenerat zum Auffrischen der Entwicklerlösung und zum Einstellen der Entwicklerwirksamkit auf einen gleichbleibenden Wert, über eine bestimmte Zeitspanne, eine unterschiedliche Abhängigkeit von dem Leitwert bzw. der elektrischen Leitfähigkeit der Entwicklerlösung haben, wobei der Leitwert von dem flächenmäßigen Durchsatz an Druckformen durch die Entwicklerlösung abhängig ist. So zeigt sich bei Verarbeitungsanlagen, bei denen die Entwicklung über den Leitwert bzw. über die Regelung des Leitwertes erfolgt, daß bei Umstellung eines eingeführten Entwicklungssystems auf ein neues Entwicklungssystem die bisher praktizierte Konstanthaltung bzw. konstante Regelung des Leitwertes, mit dem Ergebnis einer gleichbleibenden Entwicklerwirksamkeit, bei dem neuen Entwicklungssystem zu einer stetigen Abschwächung oder zu einem stetigen Anstieg der Entwicklerwirksamkeit mit daraus folgender Unbrauchbarkeit der Entwicklerlösung führt. Dadurch ist eine Nutzung der im Feld installierten Verarbeitungsanlage für das neue Entwicklungssystem aus Entwickler und Regenerat nicht möglich.

Aufgabe der Erfindung ist es, ein Verfahren zu schaffen, bei dem eine konstante Entwicklerwirksamkeit durch Zugabe von Regenerat zu einem abgeschwächten Entwickler über eine Zeitspanne sichergestellt wird, unbeeinflußt von der jeweiligen Abhängigkeit der elektrischen Leitfähigkeit der Entwicklerlösung von dem flächenmäßigen Durchsatz an Druckformen durch die Entwicklerlösung.

Diese Aufgabe wird verfahrensgemäß in der Weise gelöst, daß eine Kennlinie der spezifischen Leitfähigkeit der Entwicklerlösung bestimmt und als Sollwert-Kennlinie gespeichert wird, daß die Sollwert-Kennlinie die Veränderung der elektrischen Leitfähigkeit für eine gleichbleibende Entwicklerwirksamkeit in Abhängigkeit von dem Flächendurchsatz eines bestimmten Druckformentyps wiedergibt, daß der Ist-Wert der Leitfähigkeit der Entwicklerlösung in Abhängigkeit vom Flächendurchsatz gemessen und mit dem entsprechenden Wert der Sollwert-Kennlinie verglichen wird, und daß bei Abweichungen des Ist- von dem Sollwert entweder Wasser oder Entwicklerregenerat der Entwicklerlösung zugegeben wird, um deren Leitfähigkeit in Richtung Sollwert zu regeln.

In Ausführung des Verfahrens werden die Verweilzeit der einzelnen Druckform in der Entwicklerlösung, die Temperatur und die Bewegung der Entwicklerlösung konstantgehalten. Dabei ist davon auszugehen, daß verfahrensmäßig die Sollwert-Kennlinie für den einzelnen Druckformentyp, in Abhängigkeit von dem Flächendurchsatz der Druckformen durch die Entwicklerlösung ansteigt, konstant bleibt oder abfällt, wobei die Entwicklerwirksamkeit für den einzelnen Druckformentyp gleich bleibt.

Wenn es bei dem Verfahren zu einer Abweichung des Istwertes der Leitfähigkeit von dem Sollwert nach oben hin kommt, wird Wasser der Entwicklerlösung zur Senkung der elektrischen Leitfähigkeit zudosiert. Kommt es andererseits zu einer Abweichung des Istwertes der Leitfähigkeit gegenüber dem Sollwert nach unten hin, wird Entwicklerregenerat der Entwicklerflüssigkeit zur Erhöhung der elektrischen Leitfähigkeit zudosiert. Dabei wird die Zudosierung von Wasser oder Entwicklerregenerat in kleinen Mengen, mit Abschaltintervallen zwischen den einzelnen Dosierschritten, vorgenommen.

Im Rahmen der vorliegenden Aufgabe soll auch eine Vorrichtung zum Entwickeln von strahlungsempfindlichen, belichteten Druckformen geschaffen werden, die die Entwicklerwirksamkeit in Abhängigkeit von dem Flächendurchsatz an Druckformen auf einen konstanten Wert regelt.

Eine derartige Vorrichtung mit einer Entwicklerwanne für die Entwicklerlösung, Transportwalzenpaaren und Führungselementen für den Transport der Druckformen durch eine Entwicklerstation der Vorrichtung in einer Durchlaufebene, oberhalb der zumindest ein Sprührohr für den Antrag von Entwicklerlösung an zumindest eine Bürstwalze angeordnet ist, zeichnet sich dadurch aus, daß ein geschlossenes, mit Entwicklerlösung gefülltes Gefäß über einen Entwicklerkreislauf mit einem Entwicklerbad in der Entwicklerwanne verbunden ist, daß ein Temperaturfühler und eine Meßelektrode für die Bestimmung der elektrischen Leitfähigkeit im Inneren des Gefäßes angeordnet und an einen Rechner angeschlossen sind, in dem Daten, wie Formate der Druckformen, Sollwert-Kennlinien, welche die Veränderung der elektrischen Leitfähigkeit der Entwicklerlösung für eine gleichbleibende Entwicklerwirksamkeit in Abhängigkeit von dem Flächendurchsatz eines bestimmten Druckformentyps wiedergeben, Temperatursollwerte und Temperaturkoeffizienten für die Leitfähigkeit der Entwicklerlösung gespeichert sind und daß der Rechner an Pumpen zum Zudosieren von Entwicklerregenerat oder Wasser in das Entwicklerbad und an eine Kühleinrichtung sowie eine Heizeinrichtung innerhalb des Entwicklerbades angeschlossen ist.

Die weitere Ausgestaltung der erfindungsgemäßen Vorrichtung ergibt sich aus den Merkmalen der Ansprüche 8 bis 15.

Mit der Erfindung wird der Vorteil erzielt, daß durch die Zugabe von Regenerat zu einer abgeschwächten Entwicklerlösung die Entwicklerwirksamkeit über die gesamte Verarbeitungszeitspanne konstantgehalten werden kann, unbeeinflußt davon, ob die Kennlinie der elektrischen Leitfähigkeit der Entwicklerlösung für den einzelnen Druckformentyp in Abhängigkeit von dem Flächendurchsatz der Druckformen durch die Entwicklerlösung ansteigt, konstant bleibt oder abfällt. Durch diese Regelung der Entwicklerwirksamkeit sind Eingriffe in solche Verfahrensbedingungen, wie die Verweilzeit der Druckform in der Entwicklerlösung, in die Entwicklertemperatur und die Entwicklerbewegung, nicht erforderlich.

Im folgenden wird die Erfindung anhand der Zeichnungen näher erläutert. Es zeigen:
- Fig. 1: Kennlinien der elektrischen Leitfähigkeit von unterschiedlichen Entwicklersystemen, bestehend aus Entwickler und Regenerat, in Abhängigkeit vom Flächendurchsatz an Druckformen durch die Entwicklerlösung,
- Fig. 2: in schematischer Darstellung den Aufbau einer Vorrichtung nach der Erfindung mit einem Entwicklungsteil mit Antrag der Entwicklerlösung auf die Druckform über Sprührohre, und
- Fig. 3: in schematischer Darstellung den Aufbau einer Vorrichtung nach der Erfindung mit einem Entwicklungsteil nach dem Tauchbadprinzip.

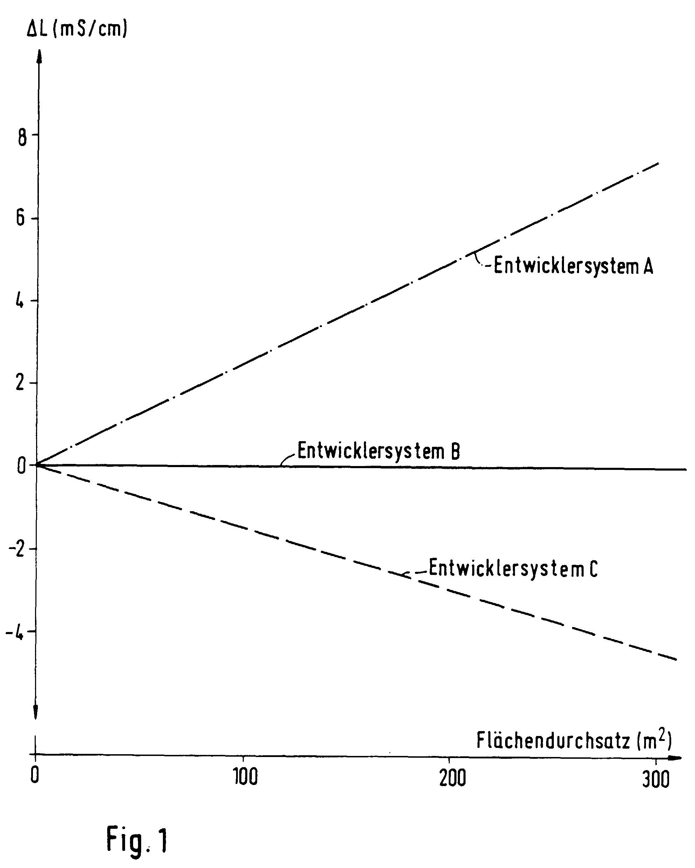

In Fig. 1 sind Kennlinien der Leitfähigkeit dreier unterschiedlicher Entwicklersysteme, die jeweils aus einer bestimmten Entwicklerlösung und einem darauf abgestimmten Regenerat der Firma Hoechst AG, Frankfurt am Main, Deutschland, bestehen, in Abhängigkeit von dem Flächendurchsatz an Druckformen dargestellt. In Ordinatenrichtung ist die Veränderung der Leitfähigkeit gegenüber frischer, ungeladener Entwicklerlösung mit der Leitfähigkeit L₀ in 10⁻³ Siemens/cm aufgetragen, und in Abszissenrichtung ist der Durchsatz an Druckformen bzw. belichteten Platten in Quadratmeter aufgetragen. Diese Kennlinien wurden jeweils in der gleichen Verarbeitungsanlage VA 85P der Hoechst AG ermittelt. Die Entwicklersysteme A, B und C zeigen unterschiedliches Verhalten in Abhängigkeit von dem Flächendurchsatz an Druckformen. Die Leitfähigkeiten zweier der dargestellten Entwicklersysteme A und C ändern sich mit dem Flächendurchsatz, je nachdem, ob der Entwickler Ionen durch Anlösen von Aluminium bzw. Al₂O₃ aus dem Aluminiumträger der Druckform zusätzlich in die Entwicklerlösung einbringt, was mit einem Anstieg der Leitfähigkeit verbunden ist, oder ob Ionen in der Entwicklerlösung abnehmen, z.B. durch elektrische Neutralisation mittels eingebrachter Kationen, wodurch dann die Leitfähigkeit des Entwicklersystems mit steigendem Flächendurchsatz an Druckformen abnimmt.

Beim Entwicklersystem B befinden sich die Zunahme und die Abnahme an Ionen in der Entwicklerlösung in etwa in Gleichgewicht, so daß die elektrische Leitfähigkeit der Entwicklerlösung während der Verarbeitungszeit weitgehend konstant bleibt. Beim Entwicklersystem A muß die Leitfähigkeit bzw. der Leitwert über den Flächendurchsatz ansteigen, damit gleichbleibende Entwicklerwirksamkeit und somit konstante Bildwiedergabe erreicht werden.

Beim Entwicklersystem B muß die Leitfähigkeit konstantgehalten werden, um gleichbleibende Entwicklerwirksamkeit und konstante Bildwiedergabe aufrechtzuerhalten. Das Entwicklersystem C erfordert eine Abnahme der Leitfähigkeit über den Flächendurchsatz, um gleichbleibende Entwicklerwirksamkeit und konstante Bildwiedergabe zu erzielen.

Aus Figur 1 ist ersichtlich, daß eine reine Leitwertmessung, die unabhängig von dem Flächendurchsatz an Druckformen erfolgt, nicht ausreicht, um die Entwicklerwirksamkeit auf einen konstanten Wert zu regeln, der allein eine gleichbleibende Bildwiedergabe gewährleistet.

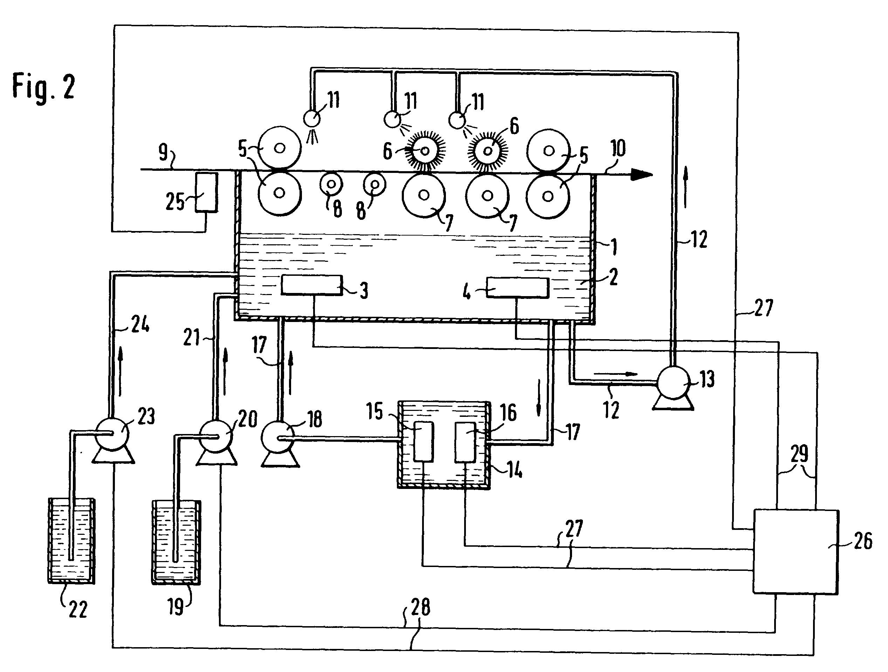

Es zeigt sich, daß die elektrische Leitfähigkeit innerhalb einer bestimmten Verarbeitungszeitspanne eine abgeleitete Größe ist, die in direkter Abhängigkeit von der verarbeiteten Druckformenfläche bzw. Plattenfläche und von konstruktiven Merkmalen der Entwicklerstation der Verarbeitungsanlage steht. Wird dabei berücksichtigt, daß die konstruktiven Merkmale der Entwicklerstation eine konstante Einflußgröße auf die Leitfähigkeit darstellen, so ergibt sich für jeden Typ einer Verarbeitungsanlage eine direkte Zuordnung einer spezifischen Leitfähigkeit für jeden Flächendurchsatz an Druckformen in einer bestimmten Entwicklerlösung. Die Erfassung der einander zugeordneten Wertepaare aus Flächendurchsatz an Druckformen und der jeweiligen elektrischen Leitfähigkeit eines bestimmten Entwicklersystems ergibt die in Figur 1 gezeigten Kennlinien als Funktion des Flächendurchsatzes. Diese Kennlinien bilden die Grundlage für die Regelung der Leitfähigkeit bzw. des Leitwertes der jeweiligen Entwicklerlösung innerhalb der Entwicklungsstation einer Verarbeitungsanlage, wie sie im folgenden anhand der Figur 2 näher erläutert wird.

Die schematische Darstellung zeigt eine Verarbeitungsanlage mit einer nicht näher bezeichneten Entwicklerstation, die eine Entwicklerwanne 1 mit einem Entwicklerbad 2 enthält. In dem Entwicklerbad 2 sind eine Kühleinrichtung 3 und eine Heizeinrichtung 4 angeordnet, die über Steuerleitungen 29 mit einem Rechner 26 außerhalb der Entwicklerstation verbunden sind. Die einzelne Druckform bewegt sich in einer Durchlaufebene 10 durch die Entwicklungsstation hindurch. Am Beginn der Entwicklungsstation befindet sich ein Anlagetisch 9 für die Druckform, unterhalb dem ein Sensor 25 angeordnet ist, der elektrisch mit dem Rechner 26 verbunden ist. Der Sensor 25 erkennt den Druckformtyp und erfaßt die Abmessungen bzw. die Fläche der einzelnen Druckform und gibt diese Daten in den Rechner 26 über eine Meßleitung 27 ein.

Für den Transport der Druckform innerhalb der Entwicklerstation und oberhalb des Entwicklerbades 2 sind jeweils am Anfang und am Ende der Entwicklungsstrecke je ein Transportwalzenpaar 5 vorgesehen. Nach dem ersten Transportwalzenpaar 5 sind Führungsrollen 8 angeordnet, die für eine plane Auflage der Druckform während der Bewegung durch die Durchlaufebene 10 bis zu den Bürstwalzen 6 sorgen. Die beiden Bürstwalzen 6 liegen an Gegenwalzen 7 an und bilden mit diesen einen Spalt, durch den die Druckform hindurchläuft. Oberhalb der Durchlaufebene 10 sind Sprührohre 11 für den Entwicklerantrag vorhanden, die über eine gemeinsame Versorgungsleitung 12 an eine Pumpe 13 für die Zufuhr von Entwicklerlösung zu den Sprührohren angeschlossen sind. Die Pumpe 13 ist mit einer weiteren Versorgungsleitung 12 direkt mit der Entwicklerwanne 1 in Verbindung, so daß jeweils Entwicklerlösung aus dem Entwicklerbad 2 in der Entwicklerwanne 1 durch die Pumpe 13 zu den Sprührohren 11 gefördert wird. Zwei dieser Sprührohre tragen den Entwickler direkt auf die Bürstwalzen 6 an, während eines dieser Sprührohre die Oberfläche der zu entwickelnden Druckform direkt unmittelbar hinter dem ersten Transportwalzenpaar 5 mit Entwickler ansprüht.

Die Elemente für die Regelung der Entwicklerwirksamkeit befinden sich außerhalb der Entwicklerwanne 1 und umfassen u.a. ein geschlossenes, mit Entwicklerlösung gefülltes Gefäß 14, das über einen Entwicklerkreislauf 17, 17 mit dem Entwicklerbad 2 in der Entwicklerwanne 1 verbunden ist. Im Inneren des Gefäßes 14, das vollständig mit Entwicklerlösung gefüllt ist, befinden sich ein Temperaturfühler 15 und eine Meßelektrode 16, die jeweils über Meßleitungen 27 mit dem Rechner 26 in Verbindung stehen. Im Entwicklerkreislauf 17, 17 ist desweiteren eine Pumpe 18 angeordnet, die dafür sorgt, daß jeweils Entwicklerlösung aus dem Entwicklerbad 2 über den Entwicklerkreislauf 17, 17 das Gefäß 14 durchströmt. Mit dem Temperaturfühler 15 wird der jeweilige Istwert der Temperatur der Entwicklerlösung in dem Gefäß 14 gemessen, während die Meßelektrode 16 die elektrische Leitfähigkeit der Entwicklerlösung erfaßt und den jeweiligen Istwert dieser Leitfähigkeit über die Meßleitung 27 dem Rechner 26 zuleitet. In dem Rechner 26 sind verschiedene Daten, wie die Formate der Druckformen, d.h. deren Flächenabmessungen, Kennlinien der spezifischen Leitfähigkeit der Entwicklerlösung für verschiedene Druckformentypen, Temperatursollwerte und Temperaturkoeffizienten für die Leitfähigkeit der Entwicklerlösung gespeichert. Desweiteren sind im Rechner Einschaltzeiten für die Pumpen 20, 23 für die Zugabe von Regenerat und Stillstandzeiten für die Pumpen 20, 23 nach einem Dosiervorgang gespeichert. Zusätzliche abgespeicherte Daten umfassen die zulässigen Regelabweichungen der elektrischen Leitfähigkeit bzw. des Leitwertes von den Sollwerten sowie den maximal zulässigen Flächendurchsatz pro Entwicklerbad.

Zur Regelung der Entwicklerwirksamkeit sind desweiteren ein Regeneratsvorratsbehälter 19, der über die Pumpe 20 und über eine Verbindungsleitung 21 mit dem Entwicklerbad 2 in Verbindung steht, und ein Wasservorratsbehälter 22 vorhanden, der über die Pumpe 23 und eine Verbindungsleitung 24 gleichfalls mit dem Entwicklerbad 2 in Verbindung steht. Die Pumpe 20 pumpt Entwicklerregenerat aus dem Regeneratsvorratsbehälter 19 über die Leitung 21 in das Entwicklerbad 2, sobald der Rechner 26 ein Ausgangssignal an den Pumpenmotor über eine erste elektrische Verbindungsleitung 28 sendet. Sendet der Rechner 26 ein Ausgangssignal an den Pumpenmotor über eine zweite elektrische Verbindungsleitung 28, so wird Wasser aus dem Wasservorratsbehälter 22 über die Leitung 24 von der Pumpe 23 in das Entwicklerbad 2 gepumpt. Von dem Rechner 26 werden desweiteren über Steuerleitungen 29 Steuersignale an die Kühleinrichtung 3 und/oder Heizeinrichtung 4 gesendet, um die Entwicklerlösung im Entwicklerbad 2 auf den Temperatursollwert einzustellen.

Die Regelung der Entwicklerwirksamkeit innerhalb eines Verarbeitungszyklus des Entwicklerbades bzw. der Entwicklerfüllung in der Entwicklerwanne 1 geschieht folgendermaßen:

Vorab werden folgende Prozeßdaten in den Rechner 26 eingegeben und gespeichert.
- Formate der Druckformen bzw. Plattenformate im Hinblick auf Breite x Länge,
- Kennlinie des Entwicklers mit positiver oder negativer Steigung der Kennlinie oder als Wertepaare elektrische Leitfähigkeit/Flächendurchsatz an Druckformen,
- Temperatursollwert des Entwicklers,
- Temperaturkoeffizient des Entwicklers für die elektrische Leitfähigkeit,
- Fördermengen der Pumpe 20 für das Regenerat und der Pumpe 23 für Wasser,
- Einschaltzeiten der Pumpen 20, 23,
- Ruhezeiten der Pumpen 20, 23 nach einem Betriebszyklus,
- Zulässige Regelabweichungen der elektrischen Leitfähigkeit vom Sollwert,
- Maximal zulässiger Flächendurchsatz an Druckformen pro Entwicklerbad.

Ändern sich die Daten der nachfolgenden Verarbeitungszyklen nicht, so werden zu Beginn jedes neuen Verarbeitungszyklus die schon eingegebenen und gespeicherten Werte automatisch wieder verwendet. Nach der Eingabe und Speicherung der Prozeßdaten in dem Rechner 26 wird die Entwicklerwanne 1 mit einem frischen Entwicklerbad 2 gefüllt und der Entwicklerkreislauf 17 eingeschaltet, d.h. die Pumpe 18 im Entwicklerkreislauf 17 in Betrieb gesetzt.

Die Entwicklerlösung im Entwicklerbad 2 wird mit Hilfe der Heizeinrichtung 3 und der Kühleinrichtung 4 auf die Solltemperatur plus/minus 2 °C temperiert. Die Temperaturmessung erfolgt, wie schon voranstehend erwähnt wurde, mit Hilfe des Temperaturfühlers 15 im Gefäß 14. Die Regelung der Kühleinrichtung 3 und der Heizeinrichtung 4 im Entwicklerbad 2 erfolgt durch die eingegebenen Daten zu dem Temperatursollwert im Rechner 26. Im nächsten Schritt wird der Basiswert bzw. der erste Sollwert der Leitfähigkeit festgelegt, der für alle folgenden Berechnungen des Sollwertes der Leitfähigkeit innerhalb eines Verarbeitungszyklus maßgebend ist. Hierzu wird die Anfangsleitfähigkeit der Entwicklerlösung im Entwicklerbad 2 mittels der Meßelektrode 16 für die Leitfähigkeit gemessen und ebenso die Temperatur der Entwicklerlösung mit Hilfe des Temperaturfühlers 15. Die bei der gemessenen Temperatur ermittelte Anfangsleitfähigkeit wird im Rechner 26 auf die vorgegebene Solltemperatur korrigiert und ist der erste Leitsollwert, der im Rechner 26 für Folgeberechnungen gespeichert wird.

Anschließend werden die zu entwickelnden Druckformen in die Entwicklerstation eingegeben. Hierbei wird der Sensor 25 zum Erfassen und Erkennen der Druckformenflächen bzw. Plattenflächen aktiviert. Aus der Anzahl der durchlaufenden Druckformen und den im Rechner 26 gespeicherten Formatangaben wird der Flächendurchsatz an Druckformen berechnet und im Rechner 26 abgespeichert.

Mit Hilfe der gespeicherten Kennlinien für die Entwicklerlösung wird ein neuer Sollwert der Leitfähigkeit in Abhängigkeit von dem Flächendurchsatz berechnet und mit dem Istwert der Leitfähigkeit der Entwicklerlösung, der mittels der Meßelektrode 16 bestimmt wird, verglichen. Der gemessene Istwert der elektrischen Leitfähigkeit wird, wie schon voranstehend erwähnt wurde, in bezug auf die Temperatur der Entwicklerlösung temperaturkompensiert. Ist die Differenz zwischen dem Soll- und dem Istwert der Leitfähigkeit innerhalb der zulässigen Regelabweichung, wie sie als Prozeßdaten im Rechner 26 gespeichert sind, so wird die Verarbeitung weitergeführt, ohne daß es erforderlich ist, die Leitfähigkeit der Entwicklerlösung nachzuregeln.

Ist die Differenz zwischen dem Ist- und dem Sollwert der elektrischen Leitfähigkeit außerhalb der zulässigen Regelabweichung der elektrischen Leitfähigkeit bzw. des Leitwertes, wie sie im Rechner 26 abgespeichert ist, so erfolgt bei einer positiven Abweichung, d.h. einer Abweichung nach oben hin, eine Zugabe von Wasser aus dem Wasservorratsbehälter 22 mit Hilfe der Pumpe 23 über die Verbindungsleitung 24 in das Entwicklerbad 2 in der Entwicklerwanne 1. Diese Wasserzugabe bewirkt eine Senkung der elektrischen Leitfähigkeit des Entwicklerbades 2.

Liegt eine negative Abweichung der Differenz zwischen dem Ist- und dem Sollwert der elektrischen Leitfähigkeit vor, so wird Regenerat aus dem Regeneratsvorratsbehälter 19 mit Hilfe der Pumpe 20 über die Verbindungsleitung 21 in das Entwicklerbad 2 gepumpt, um die elektrische Leitfähigkeit der Entwicklerlösung zu erhöhen. Das Zudosieren erfolgt in kleinen Mengen, um ein Überschwingen der Regelung auszuschließen. Zwischen jeder Zudosierung wird die jeweilige Pumpe während eines Zeitintervalls abgeschaltet, in dem keine weitere Zudosierung erfolgt, um so eine optimale Durchmischung der Entwicklerlösung im Entwicklerbad 2 mit Hilfe des Entwicklerkreislaufes 17 sicherzustellen. Das Zudosieren wird so lange wiederholt, bis die Differenz zwischen dem Ist- und Sollwert der elektrischen Leitfähigkeit sich innerhalb der zulässigen Regelabweichung im Hinblick auf die eingespeicherten Prozeßdaten bewegt.

Zwischenzeitlich können weitere Druckformen bzw. Platten der Entwicklerstation zugeführt werden, da die erforderlichen Daten fortlaufend aktualisiert werden. Zuletzt erfolgt eine Kontrolle der Summe der verarbeiteten Druckformenfläche bzw. Plattenfläche, um festzustellen, ob die als Prozeßdaten gespeicherte maximal zulässige Plattenfläche überschritten wurde oder nicht. Wurde die maximal zulässige Plattenfläche überschritten, so wird die Überwachung des Entwicklers eingestellt, um eine unerwünschte Verdrängung der Entwicklerlösung durch ständiges Hinzufügen von Regenerat zu verhindern.

### Beispiele

Nachfolgend sind Ergebnisse tabellarisch aufgeführt, die mit der Vorrichtung nach Fig. 2 erzielt wurden. Aufgeführt sind, in Abhängigkeit vom Plattendurchsatz durch die Entwickelstation, der Ist- und Soll-Leitwert zum Zeitpunkt der Plattenproduktion und die visuelle Auswertung der Platten anhand der Wiedergaben mit dem Halbtonstufenkeil HOECHST BK02 und dem UGRA-Offset-Testkeil 1982. Maßgebend für die Beurteilung der Entwicklerwirksamkeit ist dabei die Wiedergabe der Kreislinienfelder des UGRA-Offset-Testkeils 1982, welche die Grundlage des standardisierten Offsetdrucks bilden. Eine konstante Wiedergabe der Kreislinien bedeutet dabei gleichbleibende Entwicklerwirksamkeit.

Für alle nachfolgenden 3 Beispiele galten gleiche Startbedingungen bzw. Verarbeitungsbedingungen:
- Verarbeitungsanlage: Hoechst VA 85 P
- Entwicklervorgabe: 20 Liter
- Entwicklertemperatur: 22 °C
- Prozeßgeschwindigkeit: 0,8 m/min
- Schichtplatten: Hoechst P61, P5S, P63, P71, P20 gemischt
- Bildplatten: Hoechst P61
- Plattendurchsatz/Tag: variabel

| **Beispiel 1** | | | | |
|---|---|---|---|---|
| Entwickler: Hoechst EP210 Regenerat Hoechst EP310 | | | | |
| Flächendurchsatz (m²) | Soll-Leitwert (mS/cm) | Ist-Leitwert (mS/cm) | BK02 freie/ged. Stufe | UGRA-Kreislinien (µm) |
| 0 | 85,5 | 85,5 | 4/10 | 15(+) |
| 60 | 84,6 | 84,6 | 4/10(-) | 15 |
| 100 | 84,0 | 83,8 | 4/10(-) | 15 |
| 160 | 83,1 | 83,2 | 4/10(-) | 15(+) |
| 200 | 82,6 | 82,5 | 4/10(-) | 15(+) |
| 260 | 81,6 | 81,8 | 4/10 | 15(+) |

| **Beispiel 2** | | | | |
|---|---|---|---|---|
| Entwickler: Hoechst EP 26 Regenerat: Hoechst EP36 | | | | |
| Flächendurchsatz (m²) | Soll-Leitwert (mS/cm) | Ist-Leitwert (mS/cm) | BK02 freie/ged. Stufe | UGRA-Kreislinien (µm) |
| 0 | 55,9 | 55,9 | 3/9 | 15(+) |
| 60 | 55,9 | 56,2 | 3/9(-) | 15(+) |
| 100 | 55,9 | 56,1 | 3/9 | 15+ |
| 160 | 55,9 | 55,6 | 3/9(-) | 15(+) |
| 200 | 55,9 | 55,7 | 3/10 | 15(+) |
| 260 | 55,9 | 55,7 | 3/10 | 15(+) |

| **Beispiel 3** | | | | |
|---|---|---|---|---|
| Entwickler: Hoechst EP260 Regenerat: Hoechst EP361 | | | | |
| Flächendurchsatz (m²) | Soll-Leitwert (mS/cm) | Ist-Leitwert (mS/cm) | BK02 freie/ged. Stufe | UGRA-Kreislinien (µm) |
| 0 | 62,5 | 62,5 | 3/10 | 15(+) |
| 60 | 64,0 | 63,7 | 3/10(-) | 15(+) |
| 100 | 65,0 | 65,0 | 3/10- | 15(+) |
| 160 | 66,5 | 66,1 | 3/10(-) | 15(+) |
| 200 | 67,5 | 67,4 | 3/10- | 15(+) |
| 260 | 69,0 | 68,9 | 3/10- | 15(+) |

Dem Entwicklersystem des Beispiels 1 liegt eine abfallende Kennlinie Soll-Leitwert bzw. Leitfähigkeit als Funktion des Flächendurchsatzes zugrunde, was dem Entwicklersystem C in Fig. 1 entspricht. Für das Entwicklersystem des Beispiels 2 verläuft die Kennlinie Soll-Leitwert in Abhängigkeit vom Flächendurchsatz nahezu waagerecht, was dem Entwicklersystem B der Fig. 1 entspricht, während bei Beispiel 3 die Kennlinie Soll-Leitwert als Funktion des Flächendurchsatzes ansteigt, in Übereinstimmung mit dem Entwicklersystem A in Fig. 1.

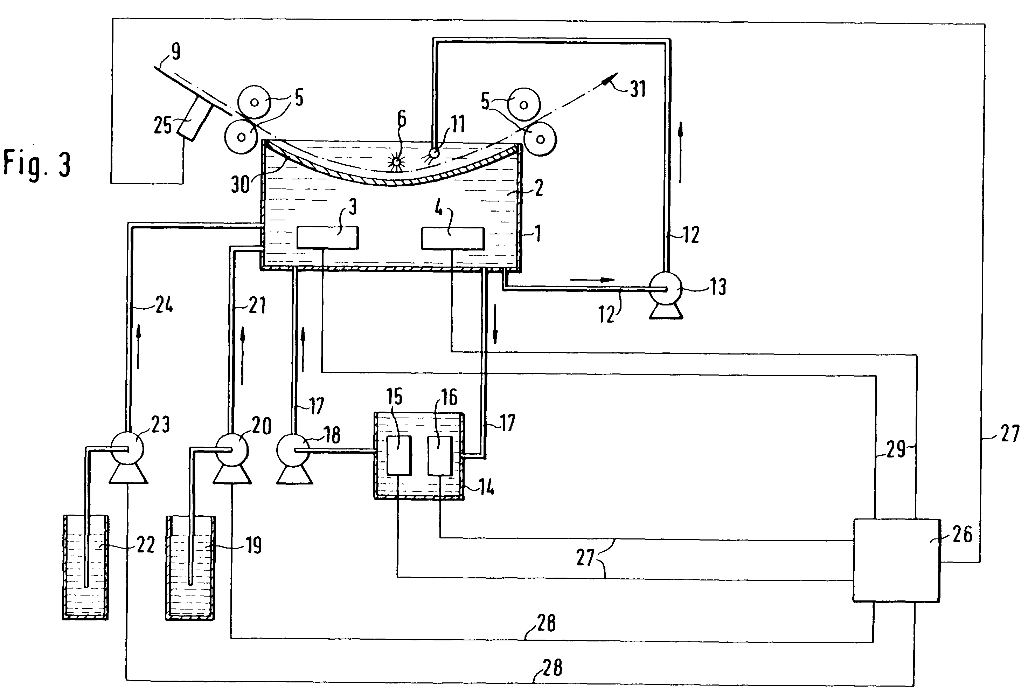

Figur 3 zeigt schematisch die Entwicklerstation einer Verarbeitungsanlage mit den konstruktiven Merkmalen einer Tauchbadentwicklung. Die Druckform taucht bei der Entwicklung direkt in die in der Entwicklerwanne 1 befindliche Entwicklerlösung 2 ein. Der Durchlauf der einzelnen Druckform erfolgt entlang einer gekrümmten Durchlaufebene 31, welche vorgegeben wird durch ein oder mehrere Führungselement(e) 30. Zu beiden Seiten der Durchlaufebene 31 befinden sich ein erstes Transportwalzenpaar 5 und ein zweites Transportwalzenpaar 5. Eine Bürstwalze 6 mit dem oder den Führungselementen 30 als Gegenlager ist dazwischen und oberhalb der Durchlaufebene 31 angeordnet. Während des Durchlaufs der Druckform wird über ein Sprührohr 11 Entwicklerlösung 2 auf die zu entwickelnde Schicht der eingetauchten Druckform unter Druck aufgebracht, um den Entwicklungsschritt zu beschleunigen.

Die Steuerung der Entwicklerwirksamkeit gleicht in ihrem Aufbau und Ablauf derjenigen, die anhand von Figur 2 beschrieben wurde.

## Patentansprüche

1. Verfahren zum Entwickeln von strahlungsempfindlichen, belichteten Druckformen in einer Entwicklerlösung, deren elektrische Leitfähigkeit fortlaufend gemessen wird, wobei in Abhängigkeit von dem Flächendurchsatz der Druckformen durch die Entwicklerlösung und der Leitfähigkeit durch Zugabe von Komponenten der Entwicklerlösung die Leitfähigkeit der Entwicklerlösung in Richtung eines Sollwertes geregelt wird, dadurch gekennzeichnet, daß eine Kennlinie der spezifischen Leitfähigkeit der Entwicklerlösung bestimmt und als Sollwert-Kennlinie gespeichert wird, daß die Sollwert-Kennlinie die Veränderung der elektrischen Leitfähigkeit für eine gleichbleibende Entwicklerwirksamkeit in Abhängigkeit von dem Flächendurchsatz eines bestimmten Druckformentyps wiedergibt, daß der Istwert der Leitfähigkeit der Entwicklerlösung in Abhängigkeit vom Flächendurchsatz gemessen und mit dem entsprechenden Wert der Sollwert-Kennlinie verglichen wird und daß bei Abweichungen des Ist- von dem Sollwert entweder Wasser oder Entwicklerregenerat der Entwicklerlösung zugegeben wird, um deren Leitfähigkeit in Richtung Sollwert zu regeln.

2. Verfahren nach Anspruch 1, dadurch gekennzeichnet, daß die Verweilzeit der einzelnen Druckform in der Entwicklerlösung, die Temperatur und die Bewegung der Entwicklerlösung konstantgehalten werden.

3. Verfahren nach Anspruch 1, dadurch gekennzeichnet, daß die Sollwert-Kennlinie für den einzelnen Druckformentyp in Abhängigkeit von dem Flächendurchsatz der Druckformen durch die Entwicklerlösung ansteigt, konstant bleibt oder abfällt, wobei die Entwicklerwirksamkeit für den einzelnen Druckformentyp gleich bleibt.

4. Verfahren nach Anspruch 1, dadurch gekennzeichnet, daß bei einer Abweichung des Istwertes der Leitfähigkeit von dem Sollwert nach oben hin Wasser der Entwicklerlösung zur Senkung der elektrischen Leitfähigkeit zudosiert wird.

5. Verfahren nach Anspruch 1, dadurch gekennzeichnet, daß bei einer Abweichung des Istwertes der Leitfähigkeit gegenüber dem Sollwert nach unten hin Entwicklerregenerat der Entwicklerflüssigkeit zur Erhöhung der elektrischen Leitfähigkeit zudosiert wird.

6. Verfahren nach Anspruch 4 oder 5, dadurch gekennzeichnet, daß die Zudosierung von Wasser oder Entwicklerregenerat in kleinen Mengen, mit Abschaltintervallen zwischen den einzelnen Dosierschritten, vorgenommen wird.

7. Vorrichtung zur Durchführung des Verfahrens gemäß Anspruch 1, mit einer Entwicklerwanne für die Entwicklerlösung, Transportwalzenpaaren und Führungselementen für den Transport der Druckformen durch eine Entwicklerstation der Vorrichtung in einer Durchlaufebene, oberhalb der zumindest ein Sprührohr für den Antrag von Entwicklerlösung an zumindest eine Bürstwalze angeordnet ist, dadurch gekennzeichnet, daß ein geschlossenes, mit Entwicklerlösung gefülltes Gefäß (14) über einen Entwicklerkreislauf (17, 17) mit einem Entwicklerbad (2) in der Entwicklerwanne (1) verbunden ist, daß ein Temperaturfühler (15) und eine Meßelektrode (16) für die Bestimmung der elektrischen Leitfähigkeit im Inneren des Gefäßes (14) angeordnet und an einen Rechner (26) angeschlossen sind, in dem Daten, wie Formate der Druckformen, Sollwert-Kennlinien, welche die Veränderung der elektrischen Leitfähigkeit der Entwicklerlösung für eine gleichbleibende Entwicklerwirksamkeit in Abhängigkeit von dem Flächendurchsatz eines bestimmten Druckformentyps wiedergeben, Temperatursollwerte und Temperaturkoeffizienten für die Leitfähigkeit der Entwicklerlösung gespeichert sind und daß der Rechner (26) an Pumpen (20, 23) zum Zudosieren von Entwicklerregenerat oder Wasser in das Entwicklerbad (2) und an eine Kühleinrichtung (3) sowie eine Heizeinrichtung (4) innerhalb des Entwicklerbades (2) angeschlossen ist.

8. Vorrichtung nach Anspruch 7, dadurch gekennzeichnet, daß in der Durchlaufebene (10) vor dem Eintritt in die Entwickelstation ein Sensor (25) zum Erfassen der Formate der Druckformen unterhalb eines Anlagetisches (9) angeordnet ist und daß der Sensor (25) elektrisch mit dem Rechner (26) verbunden ist.

9. Vorrichtung nach Anspruch 7, dadurch gekennzeichnet, daß die Pumpe (20) Entwicklerregenerat aus einem Regeneratvorratsbehälter (19) über eine Leitung (21) in das Entwicklerbad (2) pumpt, sobald der Rechner (26) ein Ausgangssignal an den Pumpenmotor über eine erste elektrische Verbindungsleitung (28) sendet.

10. Vorrichtung nach Anspruch 7, dadurch gekennzeichnet, daß die Pumpe (23) Wasser aus einem Wasservorratsbehälter (22) über eine Leitung (24) in das Entwicklerbad (2) pumpt, wenn der Rechner (26) ein Ausgangssignal an den Pumpenmotor über eine zweite elektrische Verbindungsleitung (28) sendet.

11. Vorrichtung nach Anspruch 7, dadurch gekennzeichnet, daß in dem Entwicklerkreislauf (17, 17) eine Pumpe (18) zwischen dem Gefäß (14) und der Entwicklerwanne (1) geschaltet ist, die die Entwicklerlösung durch das Gefäß (14) zirkulieren läßt.

12. Vorrichtung nach Anspruch 7, dadurch gekennzeichnet, daß der Rechner (26) über Steuerleitungen (29) Steuersignale an die Kühl- (3) und/oder Heizeinrichtung (4) sendet, um die Entwicklerlösung auf den Tempertursollwert einzustellen.

13. Vorrichtung nach Anspruch 7, dadurch gekennzeichnet, daß in dem Rechner (26) die Daten über die Fördermengen, die Einschalt- und Abschaltintervalle der Pumpen (20, 23) für den Regenerierungsvorgang der Entwicklerlösung gespeichert sind, um den Betrieb der Pumpen zu regeln.

14. Vorrichtung nach Anspruch 7, dadurch gekennzeichnet, daß die Durchlaufebene (10) der Druckformen eben ist und daß die Sprührohre (11), Transportwalzenpaare (5), Bürst- und Gegenwalzen (6, 7) sowie die Führungsrollen (8) oberhalb des Entwicklerbades (2) angeordnet sind.

15. Vorrichtung nach Anspruch 7, dadurch gekennzeichnet, daß die Durchlaufebene (31) gekrümmt ist und daß die Entwicklerstation als Tauchbad ausgebildet ist, in das die Durchlaufebene (31) zusammen mit der Bürstwalze (6) und dem Sprührohr (11) eintaucht.

## Claims

1. A process for developing radiation-sensitive, exposed printing formes in a developer solution, the electrical conductivity of which is measured continuously, the conductivity of the developer solution being regulated in the direction of a target value by addition of components of the developer solution as a function of the area throughput of the printing formes through the developer solution, characterized in that a characteristic curve of the specific conductivity of the developer solution is determined and stored as a target value characteristic curve, in that the target value characteristic curve describes the change in electrical conductivity for a constant developer activity as a function of the area throughput of a certain type of printing forme, in that the actual value of the conductivity of the developer solution is measured as a function of the area throughput and compared with the corresponding value of the target value characteristic curve, and in that in the event of deviations of the actual from the target value, either water or regenerated developer is added to the developer solution in order to regulate the conductivity thereof in the direction of the target value.

2. A process according to claim 1, characterized in that the residence time of the individual printing forme in the developer solution, the temperature and the movement of the developer solution are kept constant.

3. A process according to claim 1, characterized in that the target value characteristic curve for the individual type of printing forme increases, remains constant or decreases as a function of the area throughput of the printing formes through the developer solution, the activity of the developer remaining the same for the individual type of printing forme.

4. A process according to claim 1, characterized in that in the event of an upwards deviation of the actual value of the conductivity from the target value, water is metered into the developer solution to lower the electrical conductivity.

5. A process according to claim 1, characterized in that in the event of a downwards deviation of the actual value of the conductivity with respect to the target value, regenerated developer is metered into the developer liquid to increase the electrical conductivity.

6. A process according to claim 4 or 5, characterized in that the metering in of water or regenerated developer is carried out in small amounts, with switch-off intervals between the individual metering steps.

7. A device for carrying out the process according to claim 1, with a developer trough for the developer solution, pairs of transport rolls and guide elements for transportation of the printing formes through a developer station of the device in a passage plane, above which is arranged at least one spray pipe for application of developer solution to at least one brush roll, characterized in that a closed vessel (14) filled with developer solution is connected via a developer circulation (17, 17) to a developer bath (2) in the developer trough (1), in that a temperature sensor (15) and a measuring electrode (16) for determination of the electrical conductivity are arranged inside the vessel (14) and are connected to a computer (26), in which data, such as formats of the printing formes, target value characteristic curves which describe the change in electrical conductivity of the developer solution, for a constant developer activity, as a function of the area throughput of a certain type of printing forme, temperature target values and temperature coefficients for the conductivity of the developer solution, are stored, and in that the computer (26) is connected to pumps (20, 23) for metering regenerated developer or water into the developer bath (2) and to a cooling device (3) and a heating device (4) within the developer bath (2).

8. A device according to claim 7, characterized in that a sensor (25) for detecting the formats of the printing formes is arranged below a feed table (9) in the passage plane (10) before entry into the developing station, and in that the sensor (25) is connected electrically to the computer (26).

9. A device according to claim 7, characterized in that the pump (20) pumps regenerated developer from a regenerator reservoir tank (19) via a line (21) into the developer bath (2) as soon as the computer (26) sends an output signal to the pump motor via a first electrical connecting lead (28).

10. A device according to claim 7, characterized in that the pump (23) pumps water from a water reservoir tank (22) via a line (24) into the developer bath (2) when the computer (26) sends an output signal to the pump motor via a second electrical connecting lead (28).

11. A device according to claim 7, characterized in that a pump (18) which allows the developer solution to circulate through the vessel (14) is inserted in the developer circulation (17, 17) between the vessel (14) and the developer trough (1).

12. A device according to claim 7, characterized in that the computer (26) sends control signals to the cooling (3) and/or heating device (4) via control lines (29) in order to adjust the developer solution to the target temperature value.

13. A device according to claim 7, characterized in that the data on the delivery amounts and the switch-on and switch-off intervals of the pumps (20, 23) for the regenerating operation on the developer solution are stored in the computer (26) in order to regulate operation of the pumps.

14. A device according to claim 7, characterized in that the passage plane (10) of the printing formes is flat, and in that the spray pipes (11), pairs of transport rolls (5), brush and back-up rolls (6, 7) and the guide rolls (8) are arranged above the developer bath (2).

15. A device according to claim 7, characterized in that the passage plane (31) is curved, and in that the developer station is constructed as a dipping bath into which the passage plane (31) dips, together with the brush roll (6) and the spray pipe (11).

## Revendications

1. Procédé pour développer des formes d'impression sensibles au rayonnement, éclairées, dans une solution d'agent de développement dont la conductivité électrique est mesurée en continu, dans lequel la conductivité de la solution d'agent de développement est régulée en direction d'une valeur de consigne en fonction du débit surfacique des formes d'impression dans la solution d'agent de développement et de la conductivité par addition de composants de la solution d'agent de développement, caractérisé en ce qu'une courbe caractéristique de la conductivité spécifique de la solution d'agent de développement est déterminée et est mémorisée sous forme de courbe caractéristique de valeur de consigne, en ce que la courbe caractéristique de valeur de consigne restitue la modification de la conductivité électrique pour une efficacité constante de l'agent de développement en fonction du débit surfacique d'un type déterminé de formes d'impression, en ce que la valeur effective de la conductivité de la solution d'agent de développement est mesurée en fonction du débit surfacique et est comparée avec la valeur correspondante de la courbe caractéristique de valeur de consigne et en ce que, en cas d'écarts de la valeur effective par rapport à la valeur de consigne, de l'eau ou un produit de régénération d'agent de développement est ajoutée à la solution d'agent de développement pour réguler sa conductivité en direction de la valeur de consigne.

2. Procédé selon la revendication 1, caractérisé en ce que le temps de séjour de la forme d'impression individuelle dans la solution d'agent de développement, la température et le mouvement de la solution d'agent de développement sont maintenus constants.

3. Procédé selon la revendication 1, caractérisé en ce que la courbe caractéristique de valeur de consigne pour le type de forme d'impression individuel croît, reste constante ou décroît en fonction du débit surfacique des formes d'impression dans la solution d'agent de développement, l'efficacité de l'agent de développement pour le type de forme d'impression individuel restant constante.

4. Procédé selon la revendication 1, caractérisé en ce que, en cas d'écart vers le haut de la valeur effective de la conductivité par rapport à la valeur de consigne, de l'eau est ajoutée à la solution d'agent de développement pour abaisser la conductivité électrique.

5. Procédé selon la revendication 1, caractérisé en ce que, en cas d'écart vers le bas de la valeur effective de la conductivité par rapport à la valeur de consigne, du produit de régénération d'agent de développement est ajouté au liquide d'agent de développement pour augmenter la conductivité électrique.

6. Procédé selon la revendication 4 ou 5, caractérisé en ce que l'addition d'eau ou de produit de régénération d'agent de développement est réalisée en petites quantités, avec des intervalles d'interruption entre les différentes étapes d'addition.

7. Dispositif pour la mise en oeuvre du procédé selon la revendication 1, comportant une cuve d'agent de développement pour la solution d'agent de développement, des paires de rouleaux de transport et des éléments de guidage pour le transport des formes d'impression dans un poste de développement du dispositif dans un plan de passage au-dessus duquel est agencé au moins un tube de pulvérisation pour l'application de solution d'agent de développement à au moins un rouleau brosseur, caractérisé en ce qu'un récipient (14) fermé, rempli de solution d'agent de développement est relié par un circuit d'agent de développement (17, 17) à un bain d'agent de développement (2) dans une cuve d'agent de développement (1), en ce qu'un capteur de température (15) et une électrode de mesure (16) pour la détermination de la conductivité électrique sont disposés à l'intérieur du récipient (14) et sont reliés à un calculateur (26) dans lequel sont mémorisées des données comme les formats des formes d'impression, des courbes caractéristiques de valeurs de consigne qui restituent la modification de la conductivité électrique de la solution d'agent de développement pour une efficacité constante de l'agent de développement en fonction du débit surfacique d'un type déterminé de formes d'impression, des valeurs de consigne de température et des coefficients de température pour la conductivité de la solution d'agent de développement, et en ce que le calculateur (26) est relié à des pompes (20, 23) pour l'addition de produit de régénération d'agent de développement ou d'eau dans le bain d'agent de développement (2) et à un dispositif de refroidissement (3) ainsi qu'à un dispositif chauffant (4) à l'intérieur du bain d'agent de développement (2).

8. Dispositif selon la revendication 7, caractérisé en ce qu'un capteur (25) pour déterminer les formats des formes d'impression est disposé dans le plan de passage (10) devant l'entrée dans le poste de développement sous une table d'appui (9) et en ce que le capteur (25) est relié électriquement au calculateur (26).

9. Dispositif selon la revendication 7, caractérisé en ce que la pompe (20) pompe du produit de régénération d'agent de développement depuis un réservoir de produit de régénération (19) par l'intermédiaire d'une conduite (21) jusque dans le bain d'agent de développement (2) dès que le calculateur (26) émet un signal de sortie au moteur de la pompe par l'intermédiaire d'une première conduite de liaison électrique (28).

10. Dispositif selon la revendication 7, caractérisé en ce que la pompe (23) pompe de l'eau depuis un réservoir d'eau (22) par l'intermédiaire d'une conduite (24) jusque dans le bain d'agent de développement (2) lorsque le calculateur (26) émet un signal de sortie au moteur de la pompe par l'intermédiaire d'une deuxième conduite de liaison électrique (28).

11. Dispositif selon la revendication 7, caractérisé en ce qu'une pompe (18) qui fait circuler la solution d'agent de développement dans le récipient (14) est branchée dans le circuit d'agent de développement (17, 17) entre le récipient (14) et la cuve d'agent de développement (1).

12. Dispositif selon la revendication 7, caractérisé en ce que le calculateur (26) émet par des conduites de commande (29) des signaux de commande au dispositif de refroidissement (3) et/ou au dispositif chauffant (4) pour régler la solution d'agent de développement à la valeur de consigne de température.

13. Dispositif selon la revendication 7, caractérisé en ce que les données concernant les quantités de transport, les intervalles de mise en marche et d'arrêt des pompes (20, 23) pour le processus de régénération de la solution d'agent de développement sont mémorisées dans le calculateur (26) pour réguler le fonctionnement des pompes.

14. Dispositif selon la revendication 7, caractérisé en ce que le plan de passage (10) des formes d'impression est plan et en ce que les tubes de pulvérisation (11), les paires de rouleaux de transport (5), les rouleaux brosseurs et les contre-rouleaux conjugués (6, 7) ainsi que les galets de guidage (8) sont disposés au-dessus du bain d'agent de développement (2).

15. Dispositif selon la revendication 7, caractérisé en ce que le plan de passage (31) est incurvé et en ce que le poste de développement est sous forme de bain d'immersion dans lequel plonge le plan de passage (31) en même temps que le rouleau brosseur (6) et le tube de pulvérisation (11).
